# EUROPÄISCHE PATENTSCHRIFT

(11) **EP 3 028 854 B1**
(45) Veröffentlichungstag und Bekanntmachung des Hinweises auf die Patenterteilung: **30.08.2017**
(21) Anmeldenummer: 14196424.7
(22) Anmeldetag: 05.12.2014
(51) Int. Cl.: B32B 37/10, H01L 31/00

(54) **Verfahren zur Lamination und Formung von Solarmodulen auf Trägerstrukturen**
Method for lamination and forming of solar modules on support structures
Procédé de lamination et de formage de panneaux solaires sur des structures porteuses

(43) Veröffentlichungstag der Anmeldung: 08.06.2016
(73) Patentinhaber: Fraunhofer Gesellschaft zur Förderung der angewandten Forschung e.V., 80686 München (DE)
(72) Erfinder: Schulze, Stefan, 06114 Halle (DE); Ehrich, Christian, 04109 Leipzig (DE)
(74) Vertreter: Gagel, Roland

(56) Entgegenhaltungen:
- EP-A1- 2 698 829
- EP-A1- 2 804 224
- EP-A2- 2 441 556
- US-A1- 2013 071 961

## Beschreibung

### Technisches Anwendungsgebiet

Die vorliegende Erfindung betrifft ein Verfahren zur Lamination und Formung von Solarmodulen auf Trägerstrukturen aus einem thermomechanisch formbaren Material, bei dem eine oder mehrere Solarzellen, Leiterbahnen und Kunststofffolien sowie eine transparente Frontabdeckung als Komponenten eines Solarmoduls bereitgestellt und mit einem Laminationsprozess zur Bildung des Solarmoduls verbunden werden.

Solarmodule bestehen aus mehreren Einzelkomponenten, die in der Regel über einen Laminationsprozess miteinander verbunden werden. Hierbei werden eine oder mehrere Solarzellen sowie die zugehörigen Leiterbahnen bzw. Metallisierungen zwischen zwei Kunststofffolien als Verkapselungsmaterial platziert, welche von einem Frontglas und ggf. einer Rückseitenfolie oder einem Rückseitenglas abgeschlossen werden. Im Laminationsprozess werden diese Komponenten dann miteinander verbunden. Dünnschicht-Solarmodule oder zellbasierte Module in der Gebäudeintegration werden häufig nur mit einer Lage Verkapselungsfolie laminiert, da die Solarzellen in diesem Fall direkt auf dem Frontglas oder auf dem Rückseitenglas oder der Rückseitenfolie aufgebracht sind. Das auf diese Weise hergestellte Solarmodul wird dann auf eine dafür vorgesehene Trägerstruktur wie beispielsweise einen Aluminiumrahmen aufgebracht und an dieser befestigt. Die Trägerstruktur dient der mechanischen Versteifung des Solarmoduls. Als Trägerstrukturen eignen sich besonders Leichtbauteile, die bspw. auch mittels thermoplastisch verformbarer Organobleche oder vernetzender Prepreg-Materialien hergestellt werden können.

### Stand der Technik

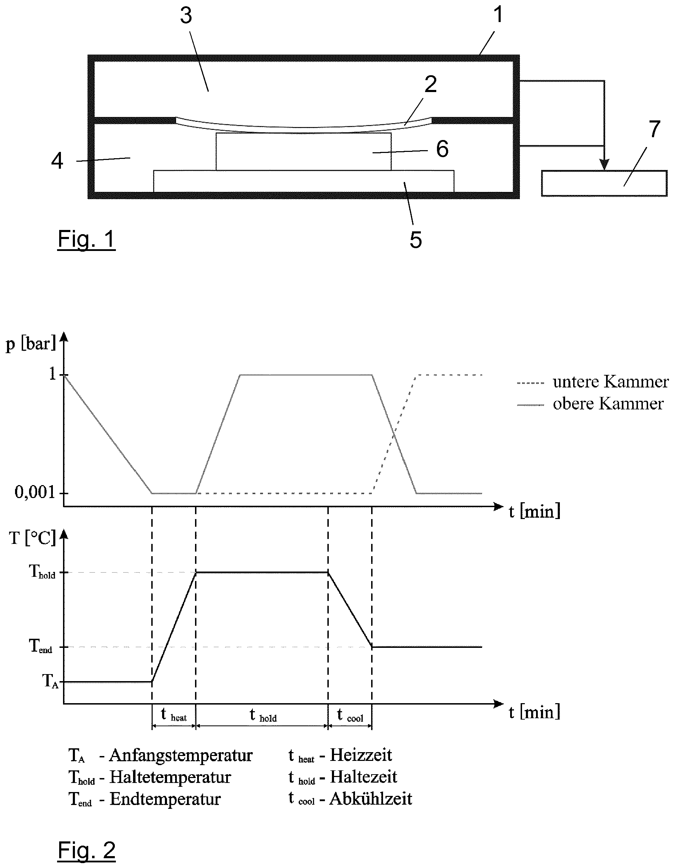

Die Verbindung der einzelnen Komponenten eines Solarmoduls erfolgt zumeist in einem Vakuumlaminationsprozess. Die einzelnen Komponenten werden dabei im Laminator übereinander platziert und anschließend bei einem Umgebungsdruck von < 1 hPa aufgeheizt und mittels einer Membran zu einem festen Laminatverbund verpresst. Figur 1 zeigt hierbei stark schematisiert einen Vakuumlaminator 1, dessen Innenraum in eine obere Kammer 3 und eine untere Kammer 4 unterteilt ist, die durch eine flexible Membran 2 luftdicht voneinander getrennt sind. Am Boden der unteren Kammer 4 befindet sich eine Heiz- und/oder Kühlplatte 5, auf der die zu verbindenden Komponenten des Solarmoduls während des Laminationsprozesses aufliegen. In der Figur 1 ist dies durch das nach der Lamination erhaltene Laminat 6 angedeutet. Der Pressdruck bei der Lamination ergibt sich aus dem Unterschied zwischen dem Kammerdruck, welchem das Laminat 6 in der unteren Kammer 4 ausgesetzt ist, und dem Druck, welcher in der oberen Kammer 3 herrscht. Die erforderlichen Druckunterschiede können durch die Vakuumpumpe 7 eingestellt werden. Das Erweichen, Aufschmelzen und ggf. Vernetzen des Verkapselungsmaterials stellt dabei einen kritischen Faktor dar. Die Temperatur im Laminat muss derart geführt werden, dass thermoplastische Materialien genügend erweicht oder aufgeschmolzen und vernetzende Materialien gezielt ausgehärtet und vernetzt werden. Figur 2 zeigt hierzu einen beispielhaften Verlauf von Temperatur und Druck in den beiden Kammern während eines Vakuumlaminationsprozesses zur Herstellung von Solarmodulen.

Die als Trägerstrukturen für die Solarmodule häufig eingesetzten Leichtbauteile werden derzeit mit unterschiedlichen Verfahren hergestellt. Ein Verfahren zur Herstellung von Leichtbauteilen mittels thermoplastisch verformbarer Organobleche oder vernetzender Prepreg-Materialien stellt der sog. Rapid Double Diaphragm Prozess (RDDF) dar. Bei diesem Verfahren wird ein Formwerkzeug mit Registerstiften unter einer Membran eingesetzt, mit dem die Trägerstruktur die gewünschte Form erhalten soll. Der flache Verbund des Prepreg-Materials wird zwischen diese und eine weitere Membran eingelegt und die Luft zwischen den Membranen evakuiert. Das Prepreg-Material wird aufgeheizt und durch Erhöhung des Kammerdrucks über der oberen Membran auf das Formwerkzeug aufgepresst. Anschließend werden die Kammern belüftet und das Bauteil freigelegt und entnommen. Es kann dann in einem Autoklaven oder durch andere externe Wärmequellen nachgehärtet werden.

Eine weitere Technik zur Herstellung von Leichtbau-Trägerstrukturen für Solarmodule stellt die sog. Resin Infusion zwischen doppelt flexiblen Membranen (RIDFT) dar. Dies ist ein zweistufiges Verfahren, bei der eine Harzinfusion und Benetzung in einer ersten Stufe, gefolgt von Vakuumformen in einer zweiten Stufe erfolgt. Die Verstärkungsfasern für das Leichtbauteil werden dabei zwischen zwei Membranen gelegt. Nach der Sicherung der Membranen wird Harz unter Druck und Vakuum in den zwischen den beiden Membranen gebildeten Hohlraum mit den Verstärkungsfasern infusioniert. Anschließend erfolgt der Schritt des Vakuumformens, bei dem die Membranen mit den getränkten Verstärkungsfasern unter Vakuum über eine männliche Form gezogen werden. Die Verwendung einer einseitigen Form bietet deutliche Kostenvorteile gegenüber dem bekannten Verfahren des Resin Transfer Moulding (RTM). Die endgültige Formgebung kann dadurch erheblich beschleunigt werden. Weiterhin ist die Form nicht in Kontakt mit dem Harz oder der Verstärkung wodurch deren Verschleiß deutlich reduziert wird.

Durch die obigen Schritte zur Herstellung der Solarmodule, der Leichtbauträgerstrukturen sowie der noch erforderlichen Verbindung der Solarmodule mit den Trägerstrukturen erfordert der Herstellungsprozess von Solarmodulen auf Trägerstrukturen eine hohe Anzahl von Prozessschritten und damit auch einen hohen Zeitaufwand. Für eine dreidimensionale Formgebung müssen das Solarmodul und die Trägerstruktur zudem hinsichtlich der Formgebung entsprechend aufeinander abgestimmt werden.

Aus EP 2 804 224 A1 ist ein Verfahren zur Herstellung eines Photovoltaikmoduls bekannt, bei dem zumindest eine mit Anschlusskontakten versehene photovoltaische Zelle auf eine Frontseitenabdeckung aufgebracht wird und nachfolgend die Frontseitenabdeckung, die Zelle und eine Rückseitenfolie durch heiß aktivierbare Klabestoffe oder durch Erwärmen unter flächigem Druck miteinander verbunden werden. In einem weiteren Schritt wird zumindest ein Bauteil mit der Rückseitenfolie des Photovoltaikmoduls verschweißt.

In US 2013/071961 A1 wird ein Laminationsverfahren zur Kapselung optoelektronischer Bauelemente wie OLEDs oder Solarzellen zwischen einer Frontschicht und einer Rückseitenschicht offenbart, bei dem die Frontschicht auf einer planen Unterlage aufliegt, wohingegen die Rückseitenschicht mit einer Membran gegen die Frontschicht bzw. das optoelektronische Element gepresst und dabei einer Verformung ausgesetzt wird.

Aus EP 2 698 829 A1 ist ein Verfahren zur Herstellung eines Solarmoduls bekannt, bei dem beim Aufbau des Solarmoduls auf der Außenseite der rückseitigen Schicht mindestens ein hitzeaktivierbares doppelseitiges Klebeband und auf diesem mindestens eine Halteplatte aufgelegt wird, wobei letztere zur Anbringung des Montagesystems bei der späteren Montage des Solarmoduls eingesetzt wird.

In EP 2 441 556 A2 wird ein Verfahren zur Fertigung von Faserverbundbauteilen in einem druckdichten Formwerkzeug offenbart, bei dem zum Abdichten des Formwerkzeugs eine fließfähige, polymere Dichtmasse zwischen zwei einander gegenüberliegenden, gegeneinander abgestützten und gegeneinander abzudichtenden Dichtflächen eingebracht und dort unter Druck fixiert wird.

Die Aufgabe der vorliegenden Erfindung besteht darin, ein Verfahren zur Lamination und Formung von Solarmodulen auf Trägerstrukturen anzugeben, das mit einer geringeren Anzahl von Prozessschritten auskommt und eine dreidimensionale Formgebung ermöglicht.

### Darstellung der Erfindung

Die Aufgabe wird mit dem Verfahren gemäß Patentanspruch 1 gelöst. Vorteilhafte Ausgestaltungen des Verfahrens sind Gegenstand der abhängigen Patentansprüche oder lassen sich der nachfolgenden Beschreibung sowie den Ausführungsbeispielen entnehmen.

Bei dem vorgeschlagenen Verfahren werden in bekannter Weise eine oder mehrere Solarzellen, Leiterbahnen und eine oder mehrere Kunststofffolien sowie eine transparente Frontabdeckung als Komponenten eines Solarmoduls bereitgestellt und mit einem Laminationsprozess zur Bildung des Solarmoduls verbunden. Das Verfahren zeichnet sich dadurch aus, dass die einzelnen Komponenten des Solarmoduls hierzu zusammen mit der Trägerstruktur oder einer Materialvorstufe der Trägerstruktur zwischen zwei Presswerkzeuge eines Laminators eingebracht, mit den beiden Presswerkzeugen gegeneinander gepresst und über den Laminationsprozess miteinander verbunden werden. Der Laminationsprozess erfolgt dabei vorzugsweise unter Einsatz wenigstens eines Formwerkzeugs als Presswerkzeug oder einer entsprechend vorgeformten starren, transparenten Frontabdeckung, durch das oder durch die die Trägerstruktur mit dem Solarmodul eine dreidimensionale, d.h. nicht-plane oder gewölbte, Form erhält.

Bei dem vorgeschlagenen Verfahren wird somit die Herstellung des Solarmoduls mit der Herstellung der Trägerstruktur in einem gemeinsamen Herstellungsprozess kombiniert. Die Herstellung des Solarmoduls und die Herstellung der Trägerstruktur, vorzugsweise eines Leichtbauträgers, erfolgen dabei nicht entkoppelt voneinander, sondern werden in einem gemeinsamen Verbindungs- und ggf. Formungsschritt durchgeführt.

Durch diese Kombination der Herstellung des Solarmoduls und der Herstellung der Trägerstruktur sowie der Verbindung des Solarmoduls mit der Trägerstruktur in einem einzigen Laminationsprozess wird eine erhebliche Reduktion der Prozessschritte gegenüber der bisherigen Vorgehensweise erreicht. Dies führt auch zu einer erheblichen Verkürzung der Prozesszeiten sowie geringeren Energiekosten und erleichtert die dreidimensionale Formung des Gesamtsystems, d.h. des Solarmoduls mit der Trägerstruktur.

Vorzugsweise erfolgt der Laminationsprozess bei dem vorgeschlagenen Verfahren ebenfalls durch Vakuumlamination. Je nach Ausgestaltung des Verfahrens können als Presswerkzeuge dabei sowohl starre Formwerkzeuge als auch flexible Membranen eingesetzt werden. Auch eine Kombination beider Werkzeugtypen ist möglich.

Für die Erzeugung einer dreidimensionalen Form kann bspw. ein entsprechend ausgebildetes Formwerkzeug eingesetzt werden, gegen das die Komponenten des Solarmoduls mit der Trägerstruktur bzw. deren Vorstufe bei der Lamination gepresst werden. Eine andere Möglichkeit besteht in der Verwendung einer bereits entsprechend vorgeformten transparenten Frontabdeckung, die in diesem Fall starr ausgebildet und eine ausreichende Festigkeit aufweisen muss. Die weiteren Komponenten sowie die Trägerstruktur bzw. deren Vorstufe werden dann bei der Lamination gegen diese starre Frontabdeckung gepresst, die in diesem Fall die Funktion eines Formwerkzeuges übernimmt.

Als Material der Trägerstruktur oder der Vorstufe der Trägerstruktur wird beim vorgeschlagenen Verfahren vorzugsweise ein thermoplastisch verformbarer Faserverbundwerkstoff (Organoblech) oder ein thermisch vernetzendes Prepreg-Material eingesetzt.

In einer Ausgestaltung des vorgeschlagenen Verfahrens wird die Trägerstruktur mit Hilfe der eingangs beschriebenen RIDFT-Technik geformt. Hierzu wird das für die Trägerstruktur erforderliche Harz unmittelbar vor dem Anpressen oder während des Pressvorganges zur Lamination in das zur Bildung der Trägerstruktur genutzte Fasergelege injiziert.

Das vorgeschlagene Verfahren bietet auch die Möglichkeit, das Solarmodul seitlich durch den Leichtbauträger bzw. die Trägerstruktur einzufassen. Hierzu werden bei dem Einlegen der einzelnen Komponenten in den Laminator die in diesem Falle überstehenden Seiten der die spätere Trägerstruktur bildenden Materiallage(n), bspw. des Prepregs oder Organoblechs, um die Ränder der Komponenten des Solarmoduls gelegt. Zusätzlich besteht die Möglichkeit, in die Halbzeuge aus Thermoplast oder Prepreg Funktionselemente, z.B. metallische Halterungskomponenten, einzulegen und diese im Prozess mit fest zu integrieren. Beim anschließenden Laminationsprozess wird dieser Aufbau dann verpresst und miteinander verbunden, so dass nach der Lamination ein entsprechend durch die Trägerstruktur eingefasstes Solarmodul erhalten wird. Durch diese Integration des Solarmoduls in den Träger wird die Modulzuverlässigkeit erhöht. In der Regel ist bei den bisherigen Techniken nur ein Aufkleben des Solarmoduls auf den Träger realisierbar.

### Kurze Beschreibung der Zeichnungen

Das vorgeschlagene Verfahren wird nachfolgend anhand von Ausführungsbeispielen in Verbindung mit den Zeichnungen nochmals näher erläutert. Hierbei zeigen:
- Fig. 1: eine schematische Darstellung eines Vakuumlaminators;
- Fig. 2: eine schematische Darstellung des Druck- und Temperaturverlaufs während eines Vakuumlaminationsprozesses;
- Fig. 3: ein Beispiel für eine Kombination von Doppel-Diaphragma- und Vakuumlaminationsprozess;
- Fig. 4: ein Beispiel für eine Durchführung des Verfahrens mit starrem Werkzeug oder abzubildender Oberfläche;
- Fig. 5: ein Beispiel für eine Durchführung des vorgeschlagenen Verfahrens mit starrer Frontseitenabdeckung ohne Werkzeug; und
- Fig. 6: ein Beispiel für eine Durchführung des vorgeschlagenen Verfahrens mit starrer Frontseitenabdeckung und Harz-Infusion.

### Wege zur Ausführung der Erfindung

Das vorgeschlagene Verfahren lässt sich in einem Vakuumlaminator durchführen, wie er in Figur 1 schematisch dargestellt ist und bereits im einleitenden Teil der Beschreibung erläutert wurde. In diesem Fall besteht das in der Figur 1 dargestellte Laminat 6 aus den Komponenten des Solarmoduls sowie der eingesetzten Trägerstruktur. Auch die Temperaturführung kann in vergleichbarer Weise erfolgen, wie dies in der Figur 2 dargestellt ist und bereits erläutert wurde.

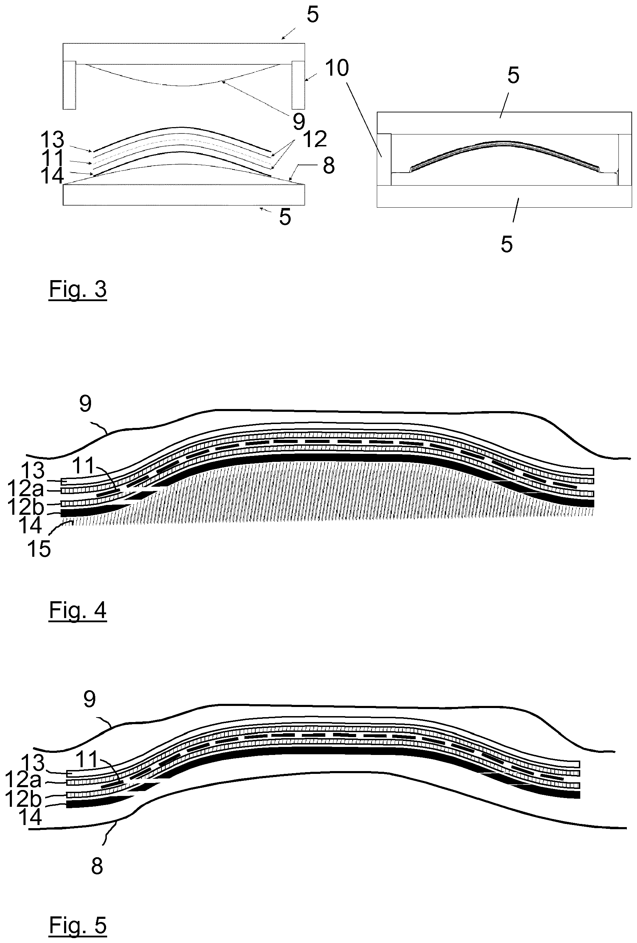

Figur 3 zeigt ein Beispiel einer Durchführung des vorgeschlagenen Verfahrens bei der eine Kombination aus Doppel-Diaphragma- und Vakuumlaminationsprozess eingesetzt wird. Im linken Teil der Figur sind hierbei einzelne Komponenten des eingesetzten Laminators zu erkennen. Dieser weist am Boden eine Heiz- und/oder Kühlplatte 5 auf, an oder über der eine untere Membran 8 befestigt ist. Der obere Bereich der Laminationskammer weist ebenfalls eine Heiz- und/oder Kühlplatte 5 auf, an oder unter der wiederum eine obere Membran 9 befestigt ist. Die beiden Laminationsmembranen 8, 9 können beispielsweise aus Gummi oder Silikon gebildet sein. Ober- und Unterteil des Laminators werden über einen Dichtrahmen 10 miteinander verbunden. Die einzelnen Komponenten des Solarmoduls, insbesondere die Solarzellen 11, die Verkapselungsfolien 12 sowie die transparente Frontseitenabdeckung 13, werden über dem Material 14 für die Trägerstruktur, im vorliegenden Beispiel einem GFK-Rückseitenträger, platziert. Dies ist im Detail auch nochmals in Figur 5 dargestellt. Die Frontseitenabdeckung 13 kann grundsätzlich aus unterschiedlichen Materialien, bspw. aus Glas, aus ETFE oder aus PMMA, gebildet sein.

Im vorliegenden Beispiel besteht diese Frontseitenabdeckung 13 aus einem starren gewölbten Glas. Bei der Durchführung des Laminationsprozesses legen sich die obere 9 und untere Membran 8 an diesen Schichtstapel an und werden über geeignete Steuerung der Druckverhältnisse in der oberen und unteren Laminationskammer gegen die dreidimensional geformte Frontseitenabdeckung 13 gepresst, um deren Form anzunehmen. Hierbei werden die beiden Heiz- und/oder Kühlplatten 5 auf eine erhöhte Temperatur gebracht. In diesem Fall übernimmt somit die Frontseitenabdeckung 13 die Funktion eines Formwerkzeugs, so dass kein entsprechendes Formwerkzeug mehr erforderlich ist.

Der Laminationsvorgang ist im rechten Teil der Figur 3 angedeutet. Anschließend erfolgt eine Abkühlung des Laminats und die beiden Membranen werden durch entsprechende Drucksteuerung in den Kammern und Abheben des oberen Teils des Laminators wieder vom fertigen Laminat 6 getrennt, so dass dieses aus dem Laminator entnommen werden kann.

Der Wärmeeintrag kann prinzipiell auch über Strahlungswärme erfolgen, so dass auf die Kühl- und/oder Heizplatten verzichtet werden kann. Weiterhin besteht die Möglichkeit, zusätzlich eine flexible Heizmatte zwischen obere Membran 9 und Frontabdeckung 13 und/oder zwischen untere Membran 8 und Trägermaterial 14 einzulegen.

Alternativ besteht auch die Möglichkeit, anstelle einer bereits vorgeformten starren Frontseitenabdeckung und der unteren Membran 9 ein starres Formwerkzeug einzusetzen, durch das die gewünschte dreidimensionale Form bei der Lamination vorgegeben wird.

Figur 4 zeigt ein Beispiel für die Durchführung des vorgeschlagenen Verfahrens, bei der ein derart starres Formwerkzeug 15 eingesetzt wird. Anstelle dieses starren Formwerkzeuges 15 könnte auch direkt ein Bauteil eingesetzt werden, dessen Oberflächenform abgebildet werden soll. Ein Beispiel für ein derartiges Bauteil ist ein Bereich einer Automobil-Außenhaut. Die einzelnen flexiblen Komponenten des Solarmoduls, d.h. in diesem Beispiel die transparente Frontseitenabdeckung 13, die Solarzellen 11, die vorderseitige Verkapselungsfolie 12a sowie die rückseitige Verkapselungsfolie 12b, und das eingesetzte Trägermaterial 14, bspw. ein noch nicht ausgehärtetes Duromer-Prepreg oder ein erweichter Thermoplast, werden auf das starre Werkzeug 15 aufgelegt. Die für die Lamination erforderliche Wärme wird entweder durch Wärmestrahlung von oben, durch die obere Membran 9 des Laminators oder durch das Werkzeug 15 selbst eingebracht. Hierdurch wird das Verkapselungsmaterial, d.h. die obere 12a und untere Verkapselungsfolie 12b aufgeschmolzen oder vernetzt und in den finalen Zustand gebracht. Gleichzeitig wird durch die Wärmezufuhr auch das als Trägermaterial 14 eingesetzte Prepreg vernetzt. Wird als Trägermaterial 14 ein bereits erweichter Thermoplast verwendet, so erstarrt dieser nach Abschluss des Prozesses. Der gesamte Laminatstapel wird während der Erwärmung über die Einstellung eines geeigneten Druckunterschieds in den beiden Kammern des Laminators durch die obere Membran 9 verpresst.

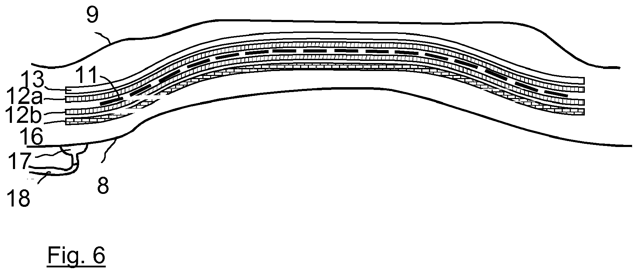

Figur 6 zeigt ein weiteres Beispiel, bei der eine starre, bereits vorgeformte Frontseitenabdeckung eingesetzt wird, die die Funktion eines Formwerkzeuges erfüllt. In diesem Fall besteht die Rückseite des Laminatstapels, d.h. die Schicht für die Trägerstruktur, aus einem Fasergelege, welches im Gegensatz zu einem Prepreg noch nicht mit Harz getränkt ist. Nach dem Anpressen des Gesamtstapels durch die Membranen 8, 9 an die starre Frontabdeckung 13 wird über eine Zuführung 18 und einen Einlassstutzen 17 flüssiges Harz in das Fasergelege 16 infusioniert. Durch den zwischen den Membranen 8, 9 angelegten Unterdruck kann das Harz das Fasergelege 16 entsprechend tränken. Nach Infusion und Vernetzung, welche durch Wärme beschleunigt wird, entsteht ein starrer Träger für das darüber liegende Solarmodul. Diese Technik der Harzinfusion kann selbstverständlich auch mit einer Verfahrensführung wie bei Figur 3 bzw. Figur 5 kombiniert werden.

### Bezugszeichenliste

- 1: Vakuumlaminator
- 2: Membran
- 3: obere Kammer
- 4: untere Kammer
- 5: Heiz- und/oder Kühlplatte
- 6: Laminat
- 7: Vakuumpumpe
- 8: untere Membran
- 9: obere Membran
- 10: Dichtrahmen
- 11: Solarzellen
- 12: Verkapselungsfolien
- 12a: obere Verkapselungsfolie
- 12b: untere Verkapselungsfolie
- 13: Frontseitenabdeckung
- 14: Material für Trägerstruktur
- 15: starres Formwerkzeug
- 16: Fasergelege ohne Harz
- 17: Einlassstuzen für Harzinfusion
- 18: Harzzuführung

## Patentansprüche

1. Verfahren zur Lamination und Formung von Solarmodulen auf Trägerstrukturen aus einem thermomechanisch formbaren Material, bei dem eine oder mehrere Solarzellen (11), Leiterbahnen und Kunststofffolien (12) sowie eine transparente Frontabdeckung (13) als Komponenten eines Solarmoduls bereitgestellt und mit einem Laminationsprozess zur Bildung des Solarmoduls verbunden werden,
**dadurch gekennzeichnet,**
**dass** die einzelnen Komponenten des Solarmoduls zunächst zusammen mit der Trägerstruktur (14) oder einer Materialvorstufe der Trägerstruktur (14) zwischen zwei Presswerkzeuge eines Laminators (1) eingebracht, mit den beiden Presswerkzeugen gegeneinandergepresst und über den Laminationsprozess miteinander und mit der Trägerstruktur (14) verbunden werden.

2. Verfahren nach Anspruch 1,
**dadurch gekennzeichnet,**
**dass** der Laminationsprozess unter Einsatz eines Formwerkzeugs (15) als eines der Presswerkzeuge erfolgt, durch das die Trägerstruktur (14) mit dem Solarmodul eine dreidimensionale Form erhält.

3. Verfahren nach Anspruch 1,
**dadurch gekennzeichnet,**
**dass** der Laminationsprozess unter Einsatz einer dreidimensional geformten starren, transparenten Frontabdeckung (13) erfolgt, durch die die Trägerstruktur (14) mit dem Solarmodul eine dreidimensionale Form erhält.

4. Verfahren nach einem der Ansprüche 1 bis 3,
**dadurch gekennzeichnet,**
**dass** die Verbindung der Komponenten des Solarmoduls und der Trägerstruktur (14) mit einem Vakuumlaminationsprozess erfolgt.

5. Verfahren nach Anspruch 4,
**dadurch gekennzeichnet,**
**dass** eine flexible Membran (8) als eines der Presswerkzeuge eingesetzt wird.

6. Verfahren nach Anspruch 4,
**dadurch gekennzeichnet,**
**dass** flexible Membranen (8, 9) als Presswerkzeuge eingesetzt werden.

7. Verfahren nach einem der Ansprüche 1 bis 6,
**dadurch gekennzeichnet,**
**dass** als Material oder Materialvorstufe der Trägerstruktur (14) ein thermoplastisches Material oder thermisch vernetzendes Material eingesetzt wird.

8. Verfahren nach einem der Ansprüche 1 bis 7,
**dadurch gekennzeichnet,**
**dass** als Trägerstruktur (14) oder Materialvorstufe der Trägerstruktur (14) ein Organoblech oder ein Prepreg eingesetzt wird.

9. Verfahren nach einem der Ansprüche 1 bis 6,
**dadurch gekennzeichnet,**
**dass** als Materialvorstufe der Trägerstruktur (14) ein Fasergelege eingesetzt wird, in das unmittelbar vor Beginn oder während des Laminationsprozesses mit Hilfe der RIDFT-Technik Harz zur Bildung der Trägerstruktur (14) eingebracht wird.

## Claims

1. Method for laminating and adapting the shape of solar modules on support structures made from a thermomechanically deformable material in which one or more solar cells (11), conductor paths and plastic foils (12) and a transparent front cover (13) are provided as components of a solar module and joined in a lamination process to form the solar module,
**characterised in that**
the individual components of the solar module are first embedded together with the support structure (14) or a material precursor of the support structure (14) between two pressing tools of a laminator (1), pressed against each other by the two pressing tools and joined to each other and to the support structure (14) via the lamination process.

2. Method according to claim 1,
**characterised in that**
the lamination process is carried out using a mould (15) as one of the pressing tools, via which the support structure (14) with the solar module is given a three-dimensional shape.

3. Method according to claim 1,
**characterised in that**
the lamination process is carried out using a three-dimensionally shaped, rigid, transparent front cover (13), via which the support structure (14) with the solar module is given a three-dimensional shape.

4. Method according to any one of claims 1 to 3,
**characterised in that**
the connection between the components of the solar module and the support structure (14) is created in a vacuum lamination process.

5. Method according to claim 4,
**characterised in that**
a flexible membrane (8) is used as one of the pressing tools.

6. Method according to claim 4,
**characterised in that**
flexible membranes (8, 9) are used as pressing tools.

7. Method according to any one of claims 1 to 6,
**characterised in that**
a thermoplastic or thermally crosslinking material is used as a material or precursor material of the support structure (14).

8. Method according to any one of claims 1 to 7,
**characterised in that**
an organic sheet or a prepreg is used as the support structure (14) or precursor material for the support structure (14).

9. Method according to any one of claims 1 to 6,
**characterised in that**
a fibre scrim is used as the precursor material of the support structure (14), in which resin is embedded by means of the RIDFT technique immediately prior to the start of or during the lamination process to form the support structure (14).

## Revendications

1. Procédé de lamination et façonnage de modules solaires sur des structures porteuses constituées d'un matériau façonnable thermomécaniquement, dans lequel une ou plusieurs cellules solaires (11), pistes conductrices et films plastique (12) ainsi qu'un couvercle avant transparent (13) sont produits comme composants d'un module solaire et sont reliés avec un processus de lamination afin de former le module solaire,
**caractérisé en ce que**
les composants individuels du module solaire sont d'abord insérés conjointement à la structure porteuse (14) ou un précurseur de matériau de la structure porteuse (14) entre deux outils de presse d'un laminateur (1), sont pressés l'un contre l'autre avec les deux outils de presse et sont reliés l'un à l'autre et avec la structure porteuse (14) par l'intermédiaire du processus de lamination.

2. Procédé selon la revendication 1,
**caractérisé en ce que**
le processus de lamination a lieu en employant un outil de façonnage (15) comme un des outils de presse, par l'intermédiaire duquel la structure porteuse (14) acquiert avec le module solaire une forme en trois dimensions.

3. Procédé selon la revendication 1,
**caractérisé en ce que**
le processus de lamination a lieu en employant un couvercle avant (13) transparent, rigide façonné en trois dimensions, par l'intermédiaire duquel la structure porteuse (14) acquiert avec le module solaire une forme en trois dimensions.

4. Procédé selon une des revendications 1 à 3,
**caractérisé en ce que**
la liaison des composants du module solaire et de la structure porteuse (14) a lieu avec un processus de lamination sous vide.

5. Procédé selon la revendication 4,
**caractérisé en ce que**
une membrane flexible (8) est employée comme un des outils de presse.

6. Procédé selon la revendication 4,
**caractérisé en ce que**
des membranes flexibles (8, 9) sont employées comme des outils de presse.

7. Procédé selon une des revendications 1 à 6,
**caractérisé en ce que**
comme matériau ou précurseur de matériau de la structure porteuse (14), un matériau thermoplastique ou un matériau à action de réticulation thermique est employé.

8. Procédé selon une des revendications 1 à 7,
**caractérisé en ce que**
comme structure porteuse (14) ou précurseur de matériau de la structure porteuse (14), une tôle organique ou un préimprégné est employé.

9. Procédé selon une des revendications 1 à 6,
**caractérisé en ce que**
comme précurseur de matériau de la structure porteuse (14), un renforcement de fibres est employé, dans lequel directement avant le début ou pendant le processus de lamination, de la résine est insérée à l'aide de la technique RIDFT afin de former la structure porteuse (14).
